# EUROPEAN PATENT APPLICATION

(11) **EP 2 456 292 A1**
(43) Date of publication of application: **23.05.2012**
(21) Application number: 11151673.8
(22) Date of filing: 21.01.2011
(51) Int. Cl.: H05K 7/20

(54) **Mounting apparatus for fans**

(30) Priority: 18.11.2010 CN 201010549460
(71) Applicant: Hon Hai Precision Industry Co., Ltd., Tu-cheng City, Taipei Hsien (TW); Hong Fu Jin Precision Industry (ShenZhen) Co., (ShenZhen) Co., Ltd., Longhua Town, Bao'an District Shenzhen City Guangdong 518109 (CN)
(72) Inventor: Zhang, Guang-Yi, 518109, Shenzhen Guangdong (CN); Fu, Jia-Qi, 518109, Shenzhen Guangdong (CN); Zhou, Hai-Chen, 518109, Shenzhen City Guangdong (CN)
(74) Representative: Wilson, Peter

(57) **Abstract**

A mounting apparatus for a fan (12) includes an enclosure (20), a mounting bracket (30) mounted to the enclosure (20), and a latch (40) mounted to the enclosure (20). The mounting bracket (30) includes a first end wall (33), and a second end wall (32) opposite to the first end wall (33). The latch (40) includes a main body (42) resisting against a top of the fan (12), a clasping tab (44) extending from a first end of the main body (42), and a locking tab (46) extending from a second end of the main body (42). The fan (12) is accommodated in the mounting bracket (30). The clasping tab (44) is mounted to the first end wall (33), and the locking tab (46) is mounted to the second end wall (32).

## Description

### BACKGROUND

### 1. Technical Field

The disclosure relates to mounting apparatuses, and particularly to a mounting apparatus configured for readily mounting fans.

### 2. Description of Related Art

In a typical computer system, fans are secured by screws or the like to an enclosure of the computer system and are used for producing a flow of cooling air over certain heat generating electronic components within the enclosure. However, when the fans are to be secured to or removed from the enclosure, installing or removing the screws one by one is inconvenient, tedious, and time-consuming.

Therefore, a mounting apparatus for fans, which can overcome the above-mentioned problems, is needed.

### BRIEF DESCRIPTION OF THE DRAWINGS

Many aspects of the present embodiments can be better understood with reference to the following drawings. The components in the drawings are not necessarily drawn to scale, the emphasis instead being placed upon clearly illustrating the principles of the present embodiments. Moreover, in the drawings, all the views are schematic, and like reference numerals designate corresponding parts throughout the several views.

FIG. 1 is an exploded, isometric view of a mounting apparatus for fans.

FIG. 2 is similar to FIG. 1, but viewed from another perspective.

FIG. 3 is an assembled, isometric view of FIG. 1.

FIG. 4 is an assembled, isometric view of FIG. 2.

### DETAILED DESCRIPTION

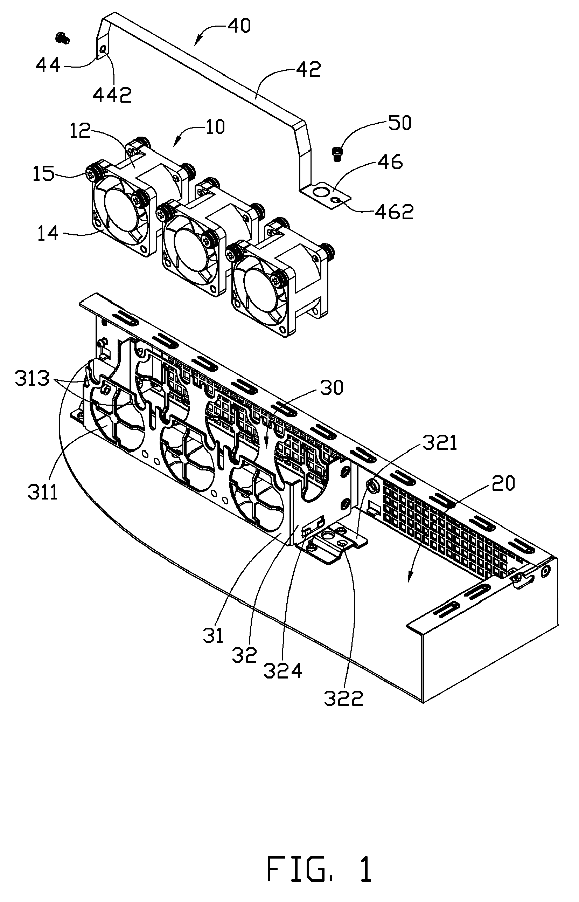

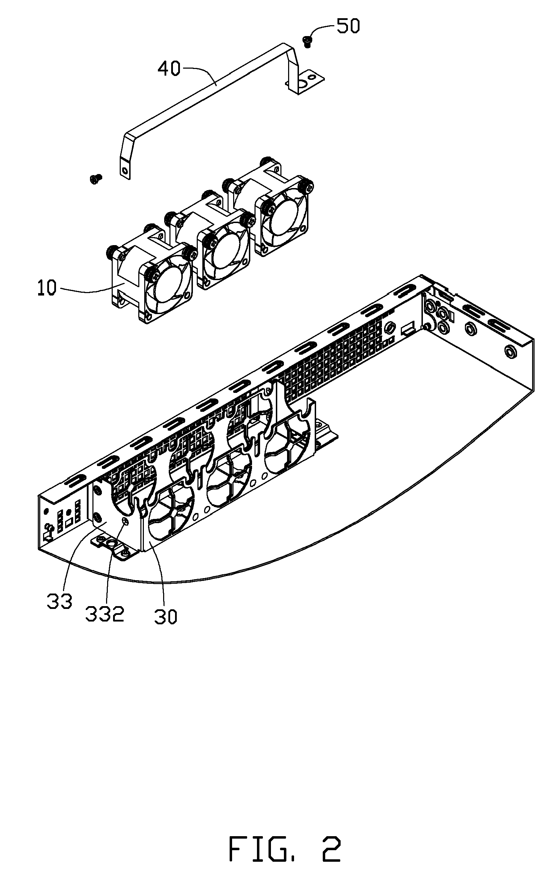

Referring to FIGS. 1 and 2, a mounting apparatus for a fan module 10 includes an enclosure 20 of an electronic device, a mounting bracket 30 latched to the enclosure 20, a latch 40 configured to mount the fan module 10 to the mounting bracket 30, and two fasteners 50 configured to mount the latch 40 to the mounting bracket 30. In this embodiment, the fasteners 50 are bolts.

The fan module 10 includes a plurality of fans 12. Each fan 12 includes two opposite sidewalls 14. Two protrusions 15 extend from an upper portion of each sidewall 14. In this embodiment, a plurality of screws (not labeled) is screwed into the upper portions of the fans 12, and the protrusions 15 are head portions of the screws protruding from the corresponding sidewall 14.

The mounting bracket 30 includes a rectangular bottom plate (not labeled) fixed to a bottom of the enclosure 20, two opposite sidewalls 31 extending from opposite sides of the bottom plate, and a first end wall 33 and a second end wall 32 extending from opposite ends of the bottom plate. The first and second end walls 33 and 32 are perpendicularly connected between corresponding ends of the sidewalls 31. Each sidewall 31 defines a plurality of substantially round-shaped vents 311. In this embodiment, a cross-shaped frame (not labeled) is formed in each vent 311. An upper portion of each sidewall 31 defines two cutouts 313 at opposite sides of each vent 311. The first end wall 33 defines a fastening hole 332. Two mounting tabs 321 substantially perpendicularly extend out from bottoms of first and second end walls 33 and 32. The mounting tabs 321 allow screws to extend therethrough to mount the mounting bracket 30 to the enclosure 20. One of the mounting tabs 321, adjacent to the second end wall 32, defines a fixing hole 322. Two substantially L-shaped clamping tabs 324 protrude out from the second end wall 32, and then extend towards each other.

The latch 40 can be a ribbon or a band-shaped clasping member made of flexible material. In this embodiment, the latch 40 includes a substantially U-shaped main body 42, a clasping tab 44 extending from a first end of the main body 42, and a locking tab 46 perpendicularly extending outward from a second end of the main body 42. The clasping tab 44 defines a fixing hole 442, and the locking tab 46 defines a fixing hole 462.

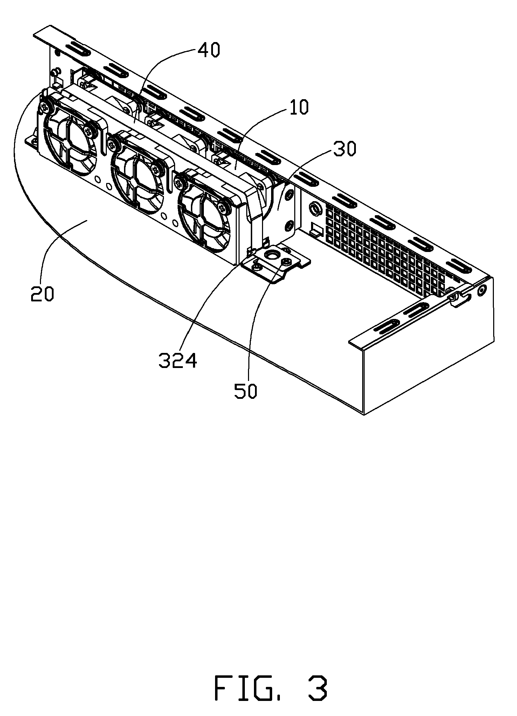

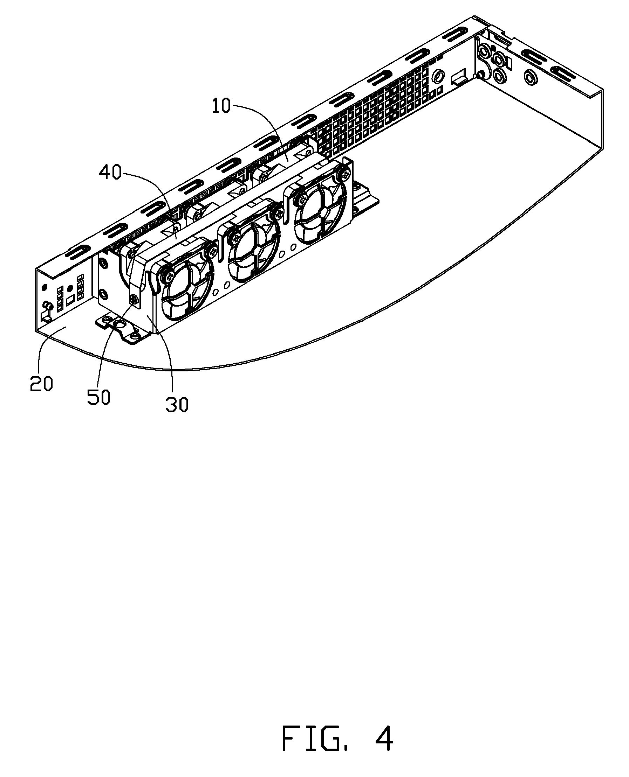

Referring to FIGS. 3 and 4, in assembly, the mounting bracket 30 is mounted to the enclosure 20 by extending screws through the mounting tabs 321 to engage with the bottom of the enclosure 20. The fan module 10 is accommodated in the mounting bracket 30, with the protrusions 15 of each fan 12 engaged in the corresponding cutouts 313 of the mounting bracket 30. The main body 42 of the latch 40 is placed on the top of the fans 12, to sandwich the fans 12 between the main body 42 and the bottom of the enclosure 20. In this state, the clasping tab 44 resists against the first end wall 33, and the locking tab 46 abuts against the mounting tab 321 adjacent to the second end wall 32. The clamping tabs 324 of the second end wall 32 elastically abut the corresponding end of the main body 42 between the second end wall 32 and the clamping tabs 324. The fasteners 50 are extended through the fixing holes 442 and 462 of the latch 40, and then correspondingly engaged in the fastening hole 332 and the fixing hole 322 of the mounting bracket 30. Therefore, the latch 40 is mounted to the mounting bracket 30, to fix the fans 12 to the bottom of the enclosure 20.

Obviously, in other embodiments, the locking tab 46 can be similar to the clasping tab 44, and mounted to the second end wall 32.

In removal of one of the fans 12, one of the fasteners 50 is released, the latch 40 is moved up and away from the mounting bracket 30, and then, the fan 12 can be readily detached from the mounting bracket 30.

It is believed that the present embodiments and theirs advantages will be understood from the foregoing description, and they will be apparent that various changes may be made thereto without departing from the spirit and scope of the description or sacrificing all of their material advantages, the examples hereinbefore described merely being exemplary embodiment.

## Claims

1. A mounting apparatus for a fan with two protrusions protruding from each of two opposite sidewalls of the fan, the mounting apparatus comprising:
an enclosure;
a mounting bracket mounted to the enclosure, comprising a first end wall, and a second end wall opposite to the first end wall, to hold the fan between the first and second end walls; and
a latch comprising a main body to hold a top of the fan, a clasping tab extending from a first end of the main body, and a locking tab extending from a second end of the main body;
wherein the clasping tab is mounted to the first end wall, and the locking tab is mounted to the second end wall.

2. The mounting apparatus of claim 1, wherein the latch is a band-shaped clasping member made of flexible material.

3. The mounting apparatus of claim 1 or claim 2, wherein the clasping tab and the locking tab each define a fixing hole, two fasteners extend through the fixing holes and then are fastened into the first and second end walls, correspondingly.

4. The mounting apparatus of claim 3, wherein two substantially L-shaped clamping tabs protrude out from the second end wall, and then extend towards each other, the main body is clamped between the clamping tabs and the second end wall.

5. The mounting apparatus of claim 4, wherein the mounting bracket comprises two opposite sidewalls substantially perpendicularly connected between the first and second end walls, an upper portion of each sidewall defines two cutouts to receive the corresponding protrusions of the fan.

6. The mounting apparatus of claim 5, wherein each sidewall defines a vent, the cutouts are located at opposite sides of the vent.

7. The mounting apparatus of claim 1, wherein the clasping tab defines a fixing hole, the first end wall defines a fastening hole, a fastener extends through the fixing hole and then is screwed into the fastening hole, to mount the clasping tab to the first end wall.

8. The mounting apparatus of claim 7, wherein the locking tab perpendicularly extends from the second end of the main body, the locking tab defines a fixing hole, a mounting tab perpendicularly extends from a bottom of the second end wall, the mounting tab defines a fixing hole, a fastener extends through the fixing hole of the locking tab, and then is screwed into the fixing hole of the mounting tab, to mount the locking tab to the second end wall.

9. The mounting apparatus of claim 8, wherein two substantially L-shaped clamping tabs protrude out from the second end wall, and then extend towards each other, the main body is clamped between the clamping tabs and the second end wall.

10. The mounting apparatus of claim 9, wherein the mounting bracket further comprises two opposite sidewalls perpendicularly connected between the first and second end walls, an upper portion of each sidewall defines two cutouts to receive the corresponding protrusions of the fan.

11. The mounting apparatus of claim 10, wherein each sidewall defines a vent, the cutouts are located at opposite sides of the vent.

12. An assembly comprising:
an enclosure;
a mounting bracket mounted to the enclosure;
a fan accommodated in the mounting bracket; and
a latch resisting against a top of the fan, wherein a first end of the latch is mounted to a first end of the mounting bracket, and a second end of the latch is mounted to a second end of the mounting bracket opposite to the first end of the mounting bracket.

13. The assembly of claim 12, wherein the latch is a ribbon.

14. The assembly of claim 12 or claim 13, wherein the mounting bracket comprises two opposite sidewalls to sandwich the fan.

15. The assembly of claim 14, wherein two protrusions extend from an upper portion of each of two opposite walls of the fan, each sidewall of the mounting bracket defines two cutouts in an upper portion of the sidewall to receive the corresponding protrusions of the fan.

16. The assembly of claim 12 or claim 13, wherein the mounting bracket comprises two end walls, with the fan accommodated between the end walls.

17. The assembly of claim 16, wherein the first end of the latch is fixed to one of the end walls, and the second end of the latch is fixed to the other end wall.
